**Europäisches Patentamt**

**European Patent Office**

**Office européen des brevets**

(19)

(11) Veröffentlichungsnummer: **0 228 517**
**B1**

(12) **EUROPÄISCHE PATENTSCHRIFT**

(45) Veröffentlichungstag der Patentschrift: **16.05.90**

(21) Anmeldenummer: **86114245.3**

(22) Anmeldetag: **15.10.86**

(51) Int. Cl.⁵: **C 30 B 13/24**

(54) **Vorrichtung zum Ziehen und Erzeugung von Kristallen.**

(30) Priorität: **28.11.85 DE 3541988**

(43) Veröffentlichungstag der Anmeldung:
**15.07.87 Patentblatt 87/29**

(45) Bekanntmachung des Hinweises auf die
Patenterteilung:
**16.05.90 Patentblatt 90/20**

(84) Benannte Vertragsstaaten:
**DE FR GB IT SE**

(56) Entgegenhaltungen:
**DE-A-2 205 558**
**GB-A-1 509 030**
**US-A-4 184 065**

(73) Patentinhaber: **DORNIER GMBH**
**Postfach 1420**
**D-7990 Friedrichshafen 1 (DE)**

(72) Erfinder: **Maschmann, H- G., Dipl.-Ing.**
**Normannenweg 130**
**D-7997 Immenstaad (DE)**
Erfinder: **Langbein, Dieter, Prof. Dr.**
**Münzenbergstrasse 8**
**D-6380 Bad Homburg (DE)**

(74) Vertreter: **Landsmann, Ralf, Dipl.-Ing.**
**c/o DORNIER GMBH Postfach 1420**
**D-7990 Friedrichshafen 1 (DE)**

Courier Press, Leamington Spa, England.

**Beschreibung**

Die Erfindung betrifft eine Vorrichtung zum Ziehen und Erzeugen von Kristallen gemäss dem Oberbegriff von Anspruch 1. Die Schwerelosigkeit, wie sie in Orbitalstationen- und Laboratorien herrscht, hat zu verschiedenen Vorschlägen zum Ziehen und Erzeugen von Kristallen geführt. Einer davon ist die Verwendung von Spiegelheizanlagen, sogenannten Spiegelöfen. Für den Experimentator sind dabei Kenntnisse über das sich während des Experimentablaufes einstellende Temperaturprofil, die Form der Schmelz- und Erstarrungsfront sowie den Einfluss zahlreicher weiterer Prozessparameter, wie Probenlage, Heizleistung des Heizstrahlers (z.B. die elektrische Wendel einer Lampe) u. a. von besonderem Interesse; sie lassen sich rechnerisch ermitteln.

Bei bisher gebauten Spiegelöfen weist die spiegelnde Fläche eine elliptische Geometrie (Rotationsellipsoid) auf, von welcher die vom Heizstrahler ausgehende Strahlung in einem Punkt der geometrischen Mittelachse des Ellipsoids konzentriert wird und die dazu führt, dass bei einer aufzuheizenden Probe mit endlichem Durchmesser die beheizte Zone nicht scharf begrenzt ist. Das heisst, je grösser der Durchmesser der Probe ist, um so grösser ist die aufgeheizte Zone. Zur Erzeugung eines Temperaturabfalls auf der dem Heizstrahler zugewandten Seite einer Probe wurde hierbei eine Verschiebung des Strahlers und/oder eine Anordnung eines Absorbers innerhalb des Ellipsoids vorgesehen. Diese Massnahme hat den Nachteil, dass es zu einer ungleichförmigen Einstrahlung mit Schattenbildung auf der Probe führt.

Aus der US—A—41 844 065 ist ein Spiegelofen bekannt, bei dem die Probe parallel zur kleinen Halbachse des Rotationsellipsoids im Bereich eines Brennpunkts angeordnet ist. Die Heizfläche befindet sich im anderen Brennpunkt. Zwischen den beiden Hälften des Rotationsellipsoids ist zur Modifikation des elliptischen Reflektors eine Abstandshülse in Richtung der grossen Halbachse angeordnet. Dadurch soll ein ungleichförmiges Schmelzen der Probe verhindert werden.

Bei einem aus der Praxis bekannten Spiegelofen, z.B. der Monoellipsoid-Spiegelanlage ELLI wird rechnerisch zunächst das auf die Probe auftreffende Einstrahlprofil bestimmt. Mittels der exakten Methode finiter Differenzen lassen sich dann der resultierende Temperaturanstieg und das stationäre Temperaturprofil in der Probe bestimmen. In Abhängigkeit von der Probenlage ist zum Erreichen eines konstanten Lösungszonenvolumens eine unterschiedliche Heizleistung (Lampenleistung) erforderlich. Exakte Ergebnisse sind hiermit für die ternären Kristalle PbSnTe und HgCdTe erreicht worden. Durch eine axial verschiebbare Anordnung des Heizstrahlers bzw. der Lampe und die damit erzielte Defokussierung sind bereits Verbesserungen des Einstrahlorofils und des Leistungsbedarfs sowie größere Züchtungslängen und ebenere Erstarrungsfronten erzielt worden. Nachteilig ist dabei noch, daß die von der heißen Probe emittierte Temperaturstrahlung nach mehreren Reflexionen an der Ellipsoidform des Spiegels auf die Probe konzentriert wird und dadurch eine Verbesserung der Temperaturverteilung nicht mehr erreicht wird. Somit ist eine Vergrößerung der Züchtungslängen und Erzeugung größerer Kristalle nicht möglich.

Aufgabe der Erfindung ist es, eine Vorrichtung zu schaffen, mit welcher die einfallende Primär- und Sekundärstrahlung auf dem Probenmaterial so verteilt wird, daß eine weitere Verbesserung des Wirkungsgrades des Spiegelofens und der Temperaturverteilung (Temperaturprofils) bei gleichzeitiger Verminderung des Leistungsbedarfs für den Heizstrahler und dadurch größere Ziehlängen bei der Erzeugung von Kristallen erreicht werden. Zugleich sollte damit auch eine Optimierung des Einstrahlprofils erzielt werden.

Die Aufgabe wird erfindungsgemäß durch die kennzeichnenden Merkmale des Anspruchs 1 gelöst. Vorteilhafte Weiterbildungen ergeben sich aus den Unteransprüchen.

Der Vorteil der Erfindung besteht darin, daß die Innenwandung das heißt, die spiegelnde Fläche des Spiegelofens durch Änderung ihrer Geometrie kein Rotationsellipsoid mehr ist.

Dadurch wird die vom Heizstrahler bzw. der Lampe ausgehende und von der Spiegelfläche reflektierte Strahlung ringförmig auf eine Umfangslinie der Probe konzentriert. Es entsteht eine Ringzone bzw. ein Ringfokus, deren Durchmesser dem Durchmesser der Probe entspricht. Dabei ergeben sich in Abhängigkeit vom Radius der Probe unterschiedliche Formen der Spiegelfläche und der Ofeninnenwand. Das heißt, daß jeder Spiegelofen mit einer solchen Kontur nur für Proben mit bestimmtem Radius optimal geeignet ist. Die Gestalt der Spiegelfläche bzw. der Innenwandung des Ofens wird nicht nur vom Radius der Probe, sondern auch von der Position des Heizstrahlers (Lampe) beeinflußt. Damit und auch in Abhängigkeit von der Bauhöhe des Spiegelofens lassen sich somit gewünschte oder erforderliche Ziehlängen von Kristallen realisieren. Durch Ausrichten des Heizstrahlers bzw. der Lampe (z.B. Halogenlampe) in der Hauptachse der veränderten Spiegelgeometrie wird eine Optimierung des Einstrahlprofils erzielt, wobei die Halterung des Heizstrahlers einen Ausgleich bei axialer und radialer Verschiebung der Heizwendel ermöglicht. Um einen bestimmten Temperaturgradienten im Probenmaterial zu erzeugen, welcher während der Kristallzüchtung möglichst konstant gehalten werden soll, ist dem Heizstrahler bzw. der Heizwendel gegenüber auf gleicher Achse eine ringförmige Kühlzone vorgesehen. Diese ist in ihrer Höhe und Wärmeübergangsfläche den Bedürfnissen der Probe angepaßt und behält während des Ziehvorgangs stets den gleichen Abstand zum Ringfokus bzw. zur Schmelzzone bei. Zum Einstellen des Temperaturprofils ist ein etwa in der Mitte des Spiegelofens angeordneter, geometrisch und bezüglich seiner Absorptionseigenschaften variabler Absorberring vorgesehen.

Ausführungsbeispiele sind nachstehend beschrieben und durch Skizzen erläutert.

Es zeigen:

Figur 1 die Spiegelfläche eines Spiegelofens mit Ringfokus im Prinzip,

Figur 2 einen schematisiert dargestellten Spiegelofen mit Heizstrahler, Probenhalterung, Kühlzone und Absorberring.

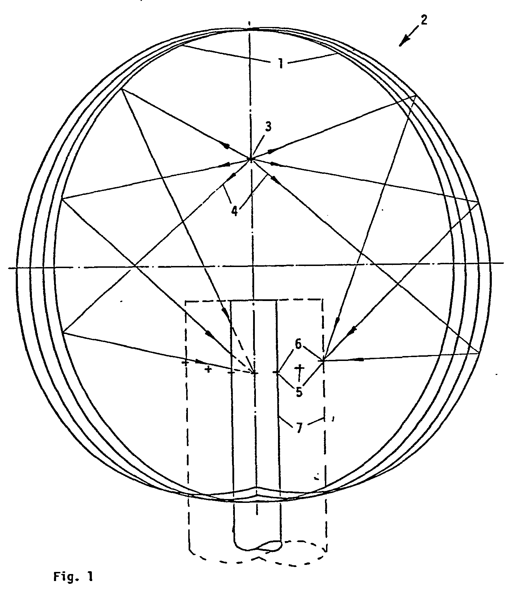

Die aus Figur 1 ersichtliche Spiegelfläche 1 eines Spiegelofens 2 weist durch die gewählte Geometrie eine apfelförmige Gestalt auf. Die von einer Heizwendel 3 ausgehende Strahlung 4 wird dabei von der Spiegelfläche 1 als Ringfokus 5 auf eine Umfangslinie 6 einer Probe 7 reflektiert.

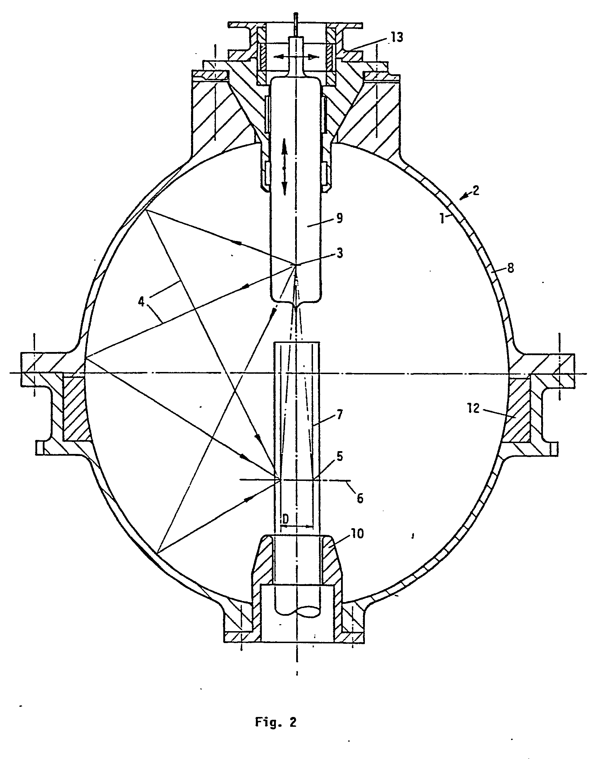

In Figur 2 ist ein Spiegelofen 2 schematisch dargestellt. Die Spiegelfläche 1 ist an der Innenwand eines Gehäuses 8 angeordnet, von welcher die von einer Heizwendel 3, z.B. einer Halogenlampe 9, ausgehende Strahlung 4 reflektiert und auf eine Umfangslinie 6 einer Probe 7 als Ring fokussiert wird.

Der Ringfokus 5 befindet sich dabei unterhalb der Halogenlampe 9 und in geringem Abstand über einer ringförmigen Kühlzone 10, die axial zur Heizwendel 3 und gegenüber der Halogenlampe 9 am Gehäuse 8 angeordnet ist. Die Halogenlampe 9 mit Heizwendel 3 ist in einer Halterung 13 vertikal und horizontal verschiebbar (siehe Richtungspfeile). Mit der ringförmigen Kühlzone 10 wird über Strahlungsaustausch und Wärmeleitung über das im Ofen vorhandene Inertgas das Temperaturprofil im unteren Bereich der Probe 7 eingestellt. Zur Einstellung des Temperaturprofils im oberen Bereich der Probe 7 ist etwa in Mitte des Gehäuses 8 bzw. der Spiegelfläche 1 ein variabler Absorberring 12 vorgesehen. Der die Schmelzzone bestimmende Ringfokus 5 weist einen Durchmesser D auf, der dem Durchmesser der Probe 7 entspricht.

**Patentansprüche**

1. Vorrichtung zum Ziehen und Erzeugen von Kristallen mit optimiertem Einstrahlungsprofil, bestehend aus einem Spiegelofen, dessen Spiegelfläche genähert ein Rotationsellipsoid ist und einer in dessen Brennpunkt axial verschiebbar angeordneten elektrisch beheizbaren Wendel als Heizstrahler, dessen Strahlung durch die eine Hälfte der Spiegelfläche in die andere Hälfte des Rotationsellipsoids konzentriert wird, in der sich eine achsparallel zur Hauptachse angeordnete und in der Wand des Rotationsellipsoids gehalterte probe befindet, dadurch gekennzeichnet, dass die Geometrie der Spiegelfläche (1) vom mathematisch exakten Rotationsellipsoid abweicht und so gewählt ist, dass die vom Heizstrahler (3, 9) ausgehende und von der Spiegelfläche (1) reflektierte Strahlung (4) als Ringfokus (5) auf eine Schmelzzone konzentriert wird, die einer Umfangslinie (6) der Probe entspricht und der Durchmesser (D) des Ringfokus (5) gleich dem Durchmesser der zu bestrahlenden und schmelzenden Probe (7) ist.

2. Vorrichtung nach Anspruch 1, dadurch gekennzeichnet, daß der Heizstrahler (3, 9) in der Hauptachse der Spiegelfläche (1) verstellbar ist.

3. Vorrichtung nach den Ansprüchen 1 und 2, dadurch gekennzeichnet, daß der Heizstrahler (3, 9) in einer axial und radial verschiebbaren Halterung (13) angeordnet ist.

4. Vorrichtung nach den Ansprüchen 1 bis 3, dadurch gekennzeichnet, daß dem Heizstrahler (3, 9) gegenüber in der Hauptachse der Spiegelfläche (1) eine in ihrer Höhe und Wärmeübergangsfläche den Bedürfnissen der Probe (7) angepaßte ringförmige Kühlzone (10) angeordnet ist.

5. Vorrichtung nach den Ansprüchen 1 bis 4, dadurch gekennzeichnet, daß der Abstand der Kühlzone (10) zur Ringfokus- und Schmelzzone (5) während des Ziehvorgangs der Kristalle immer gleich ist.

6. Vorrichtung nach den Ansprüchen 1 bis 5, dadurch gekennzeichnet, daß der Spiegelofen (2) einen in seiner Geometrie variablen Absorberring (12) aufweist.

7. Vorrichtung nach den Ansprüchen 1 bis 6, dadurch gekennzeichnet, daß der Spiegelofen (2) einen von den Wellenlängen der emittierten und reflektierten Strahlung abhängigen variablen Absorberring (12) aufweist.

**Revendications**

1. Dispositif de tirage et de génération de cristaux à profil de radiation incidente optimalisé, se composant d'un four à miroir, dont la surface du miroir est approximativement un ellipsoïde de révolution, et d'une hélice pouvant être chauffée électriquement, disposée déplaçable axialement au foyer de celui-ci, en tant qu'organe de rayonnement de chaleur, dont le rayonnement est concentré par une moitié de la surface du miroir dans l'autre moitié de l'ellipsoïde de révolution, dans laquelle se trouve en échantillon disposé parallèlement à l'axe principal et maintenu dans la paroi de l'ellipsoïde de révolution, caractérisé en ce que la géométrie de la surface du miroir (1) s'écarte de l'ellipsoïde de révolution mathématiquement exact et est choisie de sorte que le rayonnement (4) émis par l'organe de rayonnement de chaleur (3, 9) et réfléchi par la surface du miroir (1) est concentré sous la forme d'un foyer annulaire (5) sur une zone de fusion, qui correspond au contour (6) de l'échantillon et le diamètre (D) du foyer annulaire (5) est égal au diamètre de l'échantillon (7) à irradier et à fondre.

2. Dispositif selon la revendication 1, caractérisé en ce que l'organe de rayonnement de chaleur (3, 9) est déplaçable sur l'axe principal de la surface de miroir (1).

3. Dispositif selon les revendication 1 et 2, caractérisé en ce que l'organe de rayonnement de chaleur (3, 9) est disposé dans un support (13) déplaçable axialement et radialement.

4. Dispositif selon les revendications 1 à 3, caractérisé en ce que, sur l'organe de rayonnement de chaleur (3, 9) est disposée, en vis-à-vis sur l'axe principal de la surface de miroir (1), une zone de refroidissement (10) annulaire adaptée en hauteur et en surface de transmission de chaleur aux besoins de l'échantillon (7).

5. Dispositif selon les revendications 1 à 4, caractérisé en ce que l'écartement de la zone de refroidissement (10) par rapport à la zone de foyer annulaire et de fusion (6) est constamment égal durant le processus de tirage des cristaux.

6. Dispositif selon les revendications 1 à 5, caractérisé en ce que le four à miroir (2) présente un anneau absorbeur (12) à géométrie variable.

7. Dispositif selon les revendications 1 à 6, caractérisé en ce que le four à miroir (2) présente un anneau absorbeur (12) variable en fonction des longueurs d'onde du rayonnement émis et réfléchi.

## Claims

1. An apparatus for pulling and generating crystals with an optimised irradiation profile and comprising a reflector furnace, the reflective surface of which is virtually an ellipsoid of rotation and comprising, disposed for axial displacement at the focal point thereof, an electrically heatable spiral which serves as a heat irradiator, the radiation of which is concentrated through one half of the reflective surface into the other half of the ellipsoid of rotation in which there is a sample disposed axially parallel with the main axis and supported in the wall of the ellipsoid of rotation, characterised in that the geometry of the reflective surface (1) diverges from the mathematically accurate ellipsoid of rotation and is so chosen that the rays (4) emanating from the heat irradiator (3, 9) and reflected by the reflective surface (1) are concentrated as an annular focus (6) on a fusion zone which corresponds to a peripheral line (6) on the sample, the diameter (D) of the annular focus (5) being equal to the diameter of the sample (7) which is to be irradiated and fused.

2. An apparatus according to Claim 1, characterised in that the heat irradiator (3, 9) is adjustable in the main axis of the reflective surface (1).

3. An apparatus according to Claims 1 and 2, characterised in that the heat irradiator (3, 9) is disposed in an axially and radially displaceable support (13).

4. An apparatus according to Claims 1 to 3, characterised in that opposite the heat irradiator (3, 9) there is in the main axis of the reflective surface (1) an annular cooling zone (10) adapted in its height and heat transfer surface to the requirements of the sample (7).

5. An apparatus according to Claims 1 to 4, characterised in that the distance between the cooling zone (10) and the annular focus and fusion zone (5) is always the same during the process of crystal pulling.

6. An apparatus according to Claims 1 to 5, characterised in that the reflector furnace (2) comprises an absorber ring (12) which is of variable geometry.

7. An apparatus according to Claims 1 to 6, characterised in that the reflector furnace (2) comprises an absorber ring (12) which is variable as a function of the wavelengths of the emitted and reflected rays.

Fig. 1

Fig. 2